# EUROPEAN PATENT APPLICATION

(11) **EP 3 503 230 A1**
(43) Date of publication of application: **26.06.2019**
(21) Application number: 17209735.4
(22) Date of filing: 21.12.2017
(51) Int. Cl.: H01L 39/24, H01L 39/14, H01F 6/06

(54) **MAGNESIUM DIBORIDE SUPERCONDUCTING WIRE WITH MAGNESIUM COATED IRON SHEATH AND METHOD OF OBTAINING**

(71) Applicant: Abant Izzet Baysal Universitesi, Bolu Turkey (TR)
(72) Inventor: BELENLI, Ibrahim, BOLU (TR); YETIS, Hakan, BOLU (TR); AKDOGAN, Mustafa, BOLU (TR); KARABOGA, Furat, BOLU (TR)
(74) Representative: Yamankaradeniz, Kemal

(57) **Abstract**

This invention is related to monocore and/or multifilamentary MgB2 superconducting wires with internally Mg coated iron sheath for their use in the technological field of superconductivity and fabrication of said wires by in-situ method.

## Description

### Technical Field

This invention is related to the fabrication of a magnesium diboride superconductor wire by using a magnesium coated iron sheath and it's obtaining method.

In particular, this invention is related to the fabrication of in-situ processed monocore and/or multifilamentary MgB₂ wires employing internally Mg-coated Fe tubes/ sheaths in order to be used in superconductor technologies.

### Background Art

Superconducting materials have unique properties so that their electrical conductivity becomes infinite under certain conditions. Some elements and alloys gain superconducting properties when they are cooled to a certain temperature (critical temperature: T_{c}) or below the critical temperature. Electric current can pass through superconducting materials without encountering resistance. Another feature is that the magnetic flux inside a superconductor is entirely expelled due its property of perfect diamagnetism which is known as the Meissner effect. Superconducting materials can carry very high currents. Superconductors are used in applications such as magnetic energy storage systems, motors, generators, transformer, computer parts, high speed trains, magnetic resonance imaging (MRI), very sensitive magnetic field detectors, current and voltage measuring devices.

Magnesium diboride (MgB₂) superconductor is a compound of refined boron which is also used in advanced technologies such as fuel cells and requires advanced technology in its production. The importance and attractiveness of this superconductor is elevated due to the facts that MgB₂ is superconducting at 39K (-234 °C; -389 °F); its components are cheap and abundant and its synthesis is easy and simple. MgB₂ materials (wire, pellet, film, etc.) having critical current densities greater than 10⁴ A/cm² can be made by sintering at temperatures between 650 and 850 °C from B and Mg powders.

MgB₂ superconducting wires are produced by in-situ or ex-situ methods. Different metals (iron (Fe), copper (Cu), silver (Ag), titanium (Ti), niobium (Nb), nickel (Ni), tantalum (Ta)) and/or metallic composites (steel, monel, GlidCop) are used as cladding materials in the production of these wires.

The performance of the wires produced by the ex-situ method is lower than those produced by the in-situ method. Despite all the advances recorded in in-situ MgB₂/Fe superconductor wires up to date, full performance has not been achieved due to the undesirable reactions between the iron sheath material and the Mg+2B core. Current solution is to use a barrier material between the Mg + 2B core and the inner wall of the iron (Fe) sheath. These barrier materials are the materials as ex-situ MgB₂, Ti, Nb or NbTi. The use of ex-situ MgB₂ powder or its bulk form as barrier material has problems due to difficulty in obtaing thickness uniformity between the iron sheath and the in-situ core. On the other hand, it has to be applied as a thick layer undesirably reducing the in-situ Mg+2B ratio in the wire cross-section. Barrier materials such as Nb and Ti are expensive and increase material costs. In addition, such barrier materials are used in the form of metal tubes and this leads to reduced superconducting ratio of the wire cross-section because they have to be thick enough and robust to the wire drawing and rolling processes.

In current production techniques, magnesium and boron Mg + 2B powders are first filled into Nb or Ti tubes and then placed in Cu and Fe tubes and wire drawing or rolling process is continued. In this technique, the superconducting cross section ratio is reduced due to the use of extra tubes. In addition, the high costs of Nb and Ti increase the total wire cost.

Fe sheath can be used successfully as a barrier in ex-situ wires since the MgB₂ phase is chemically stable but this is not the case in in-situ wires since boron is a very reactive element and rapidly reacts with Fe sheath material. Consequently, deterioration in the wire performance occurs due to the reactions between the core (Mg+2B) and sheath material (Fe), when the in-situ MgB₂ wires are made using iron tubes without any barrier material. In addition, since B atoms are very small, they can penetrate into other materials at heat treatment temperatures.

Other materials such as Cu, which may be used in the aforementioned techniques, deteriorate the superconducting properties by creating an adverse effect on MgB₂. The metal sheaths in this group react with Mg and affect the chemical stoichometry.

On the other hand, when ex-situ MgB₂ is used as the barrier, a performance loss occurs and the in-situ production technique is partially distorted. Ex-situ and in-situ methods are different in terms of the optimum production parameters thus full performance can not be achieved.

Currently, there are mainly three methods of magnesium (Mg) coating process. Although there are many studies on the coating of Zn-Mg-Al alloys on iron and steel, when their methods and purposes are considered they are inappropriate to our case in terms of application areas. In the coating methods made by dipping into molten Mg and Mg alloys, additional methods are needed to be developed for coating the inner walls only as well as thinner coating. MgB₂ bulk specimens and wires produced by the internal magnesium diffusion method called IMD are available in the literature, but magnesium bars are placed at the center and B powders are placed between the iron tube and bars in this method. With this method, although the samples with high current densities are produced, the interaction of boron with inner wall of iron is not prevented. In addition, it is not possible to produce sufficiently long (km scale) wires by this method.

When the relevant literature is searched, the following patent application is found.

This US patent application entitled "Fabrication method of a MgB₂ superconducting tape and wire" of US Pat. No. US8173579 (B2) relates to the method of producing MgB₂ superconductor wire and tape. More specifically, it is directed to the production of ex-situ MgB₂ superconducting wires and tapes having a homogeneous current density (J_{c}) over the wire length for practical use.

The Japanese patent application entitled "Creating method for MgB₂ superconducting wire" of JP2003331670 (A) relates to MgB₂ superconducting wire production method. The method comprises mixing the MgH₂ powder and the B powder to form a tape or a wire in a metal tube and form a reaction between the MgH₂ and B by heating in a temperature range of 500 °C to 1000 °C in an inert gas atmosphere.

When the above patents are examined, the sheath materials used in the inventions do not contain Mg coating, so they can not provide solutions to the existing problems. As a result, an improvement in the technical field has become necessary due to the above-mentioned drawbacks and the inadequacy of the existing solutions.

### Object of the Invention

The present invention relates to MgB₂ superconducting wire and method of manufacturing that meets the above-mentioned requirements, removes all disadvantages and adds some additional advantages.

The primary object of the invention is to obtain monocore and/or multiflamentary MgB₂ superconducting wires by using magnesium (Mg) coated iron (Fe) sheath in order to use in the field of superconducting technology and to present the in-situ method used in.

One object of the invention is to prevent the contact between the Mg+2B core and the inner wall of the Fe sheath by Mg-coating of the inner wall of the Fe sheath, inhibiting the diffusion of B into the Fe.

One object of the invention is to obtain a MgB₂ superconducting wire in which the Mg is coated on the inner wall of the Fe sheath as a thin layer and the superconductor ratio in the cross section is higher than in existing techniques.

A similar object of the invention is to obtain Fe/MgB₂ superconductor wire with Mg coating layer that maintains its continuity and affects on all interface walls during wire drawing because Mg is a ductile and soft material.

A similar aim of the invention is to provide MgB₂ superconducting wire having a high electrical conductivity layer between the Fe sheath and MgB₂ is formed by virtue of the internally coated Mg layer.

One aim of the invention is to eliminate the inconveniences encountered in the in-situ MgB₂ wires prepared by the excess Mg mixing method.

One object of the invention is to obtain a lower cost MgB₂ superconducting wire compared to wires produced by other techniques.

In order to achieve the above mentioned purposes, the invention is related to the magnesium diboride superconducting wire for use in superconducting technology, consisting of monocore and/or multifilamentary, coated iron sheath, magnesium powder, amorphous boron powder, amorphous nano boron powder and it is characterized in that it consists of magnesium coating in inner wall of the said iron sheath.

In order to achieve the above mentioned purposes, the invention is related to production method to obtain magnesium diboride superconducting wire for use in superconducting technology, consisting of monocore and/or multifilamentary, coated iron sheath, magnesium powder, amorphous boron powder, amorphous nano boron powder and it is characterized in that it consists of method steps of:
a) In-situ preparation of a mixture of magnesium diboride components,
b) Coating of the inner wall of the iron sheath with magnesium by sublimation and evaporation method,
c) Preparation of magnesium diboride superconducting wire by PIT / PEIT wire drawing-sintering method and inner wall magnesium coated iron sheath.

The structural and characteristic features of the invention and its all advantages will be more clearly understood by means of the following figures and detailed descriptions which are made by referring to these figures, and therefore the evaluation should be made taking these figures and detailed explanation into consideration.

### Brief Description of the Figures

Figure 1 shows superconducting transition widths of MgB₂ wires produced by means of Mg-coated and uncoated iron sheaths under the same experimental conditions.
Figure 2 shows the onset superconducting transition temperatures of MgB₂ wires produced by means of Mg-coated and uncoated iron sheaths under the same experimental conditions.
Figure 3 shows the offset superconductivity transition temperatures of MgB₂ wires produced by means of Mg-coated and uncoated iron sheaths under the same experimental conditions.
Figure 4. (a) J-E behaviour of the wires produced by using Mg coated iron sheath for an applied current between 0-1 A at 36.8 K which is 0.5 K or less below T_{c offset} temperatures of the samples. (b) J-E behaviour of the wire, produced by uncoated iron sheath and annealed at 750 °C for 2 hours, is shown at 35 K and 36 K wh ich are more than 1 K below T_{c offset} of the related samples.
Figure 5 J_{c}-E curves of MgB₂ wires produced with uncoated iron sheath and sintered at different temperatures are shown at 28K and under 4.5 T magnetic field.
Figure 6 J_{c}-E curves of MgB₂ wires produced in the Mg-coated iron sheath and sintered at different temperatures are shown at 28K and under 6.75 T magnetic field.
Figure 7 shows the critical current density values of MgB₂ wires produced by Mg-coated iron sheath (on the inner surface) under high magnetic fields at 4.2 K temperature (in liquid helium).
Figure 8 XRD patterns of MgB₂ wire samples produced by Mg-coated (a) and uncoated (b) iron sheaths sintered at different temperatures are shown.
Figure 9 shows electron microscopy images of the fructured surface obtained from MgB₂ core of Mg-coated (a) and uncoated (b) iron sheathed wires.

### Detailed Description of the Invention

In this detailed description, the MgB₂ superconductor wire and preferred embodiments and the method of obtaining and the preferred parameters are disclosed in order to provide a better understanding of the invention and not to impose any limiting effect.

The invention is related to the magnesium diboride (MgB₂) superconducting wire to be used in superconducting technology, consisting of monocore and/or multifilamentary iron (Fe) sheath with inner wall coated with magnesium (Mg) and in-situ obtaining of the said wire. Raw materials and weight usage ratios used in this method are given in Table 1 below.

| **Element Contained** | **Chosen Amount of Mass (%)** | **Possible Amount of Mass (%)** |
|---|---|---|
| Iron Sheath | 61 | 50-85 |
| Magnezium (Mg) Coating | 1 | 0,1-10 |
| Magnezium (Mg) Powder | 20 | 7-26 |
| Amorphous Boron (B) Powder | 9 | 0,1-25 |
| Amorphous Nano Boron (nB) Powder | 9 | 0,1-25 |
| TOTAL | 100 | |

The present invention discloses obtaining method of magnesium diboride (MgB₂) superconducting wire in iron iron sheathing which is intyernally coated with magnesium (Mg). The three main method steps of the method are the following;

### Step 1: In-situ preparation of a mixture of magnesium diboride components (Mg + 2B)

The metal magnesium powder (Mg) (100-200 mesh), amorphous boron powder (B) (∼1µm) and amorphous nano boron power (nB) (max. 250nm) are weighed out in the amounts indicated in Table 1 preserving the chemical stoichiometry of MgB₂. The mixture (Mg+2B) is milled at 50-500 rpm for 1-12 hours under a 1-5 bar argon gas pressure by a ball milling method.

### Step 2: Coating of the inner wall of the iron sheath with magnesium by sublimation and evaporation method

Seamless iron tube with an inner diameter of 9 mm and length of 150 mm is preferred as the iron (Fe) sheath. The inner and outer walls of the sheath are thoroughly cleaned by using ultrasonic vibration with alcohol and/or acetone, and then the bottom end is pressed and closed. The flattened bottom end is sealed by friction welding. The closed bottom end is subjected to a leakage test under 2 bar air pressure.

0.5 g Mg powder (100-200 mesh) is filled from the open end of the sheath in an amount which is proportional to the volume of the tube (0.1 g for each 1 cm³). Subsequently, the open end of the iron tube is also lightly pressed flat without perfect sealing. In this way, evacuation and argon filling processes which are applied during heat treatment can affect inside the iron tube. Iron tube with closed ends and metallic Mg powder contained inside is placed in a steel cylindrical container. Then, this steel cylindrical container is completely closed and inserted into the vertical furnace from the top. The heating process is started at room temperature reaches to 600°C with a heating rate of 5°C/min. When heating is started, vacuuming, filling argon gas of 1.5 bars high purity and re-vacuuming are successively applied to cylindrical steel chamber until the furnace temperature reaches 100ºC. When the temperature of the furnace reaches 200 °C, the steel cylindrical chamber is again washed with 1.5 bar argon gas, vacuumed and then heated to 600 °C in an argon pressure of 1.5 bar. When the furnace temperature reaches 600 °C, steel chamber is vacuumed and heat treatment is applied under vacuum for 1 hour at this temperature. After being held at 600 °C for 1 hour, it is washed again with 1.5 bar argon gas and vacuum is filled and kept at the same temperature for 1 hour. Then the furnace is closed and left to cool under 2 bar of argon. The steel container cooled down to room temperature and the internally Mg-coated Fe sheath is removed from the furnace.

What should be noted in the method of coating the inner wall of the Fe sheath with Mg is to ensure that the coating is homogeneous, continuously uniform and MgO formation is prevented.

In the method described above, metallic Mg deposits on the inner walls of the Fe sheath by sublimation and evaporation at high temperature under vacuum and/or inert gas pressure to form a layer. The thickness of the Mg coating layer can be controlled by the amount of Mg powder, heat treatment duration and heat treatment temperature. However, the coating of the inner walls of the iron sheath with Mg is not limited to this method. The thickness of the Mg coating layer can also be controlled by using different coating techniques.

### Step 3: Preparation of magnesium diboride superconducting wire by PIT / PEIT wire drawing-sintering method and magnesium coated iron sheath

In the first step, a composite is prepared by filling the in-situ Mg + 2B powder mixture into the Mg-coated Fe sheath. If Mg + 2B powder mixture is filled into Fe sheath in powder form, this filling method is called powder in tube method (PIT-powder in tube). If the prepared Mg + 2B powder mixture is brought into disc shaped pellets by hydraulic pressing and these pellets are filled into Fe sheath under vacuum, this filling method is called pellets in tube method (PeIT- pellets in tube).

The prepared composite is cold drawn by passing it through a circular dies with cold wire drawing method, and MgB₂ wire is reduced to the desired diameter. In the preferred embodiment of the invention, the 9 mm outer diameter composite is thinned to a diameter of 0.8 mm by cold wire drawing method. During wire drawing, intermediate heat treatments are applied at 500°C in argon gas flow for strain relief. At the end of the wire drawing process, 150 mm long pieces are cut from a long wire with 0.8 mm diameter. These pieces of wires are then heat-treated (sintered) under 5-10 bar argon gas pressure in a horizontal furnace for 1-2 hours at 700°C-750°C temperatures. At the end of the sintering process, MgB₂ superconducting wires with Mg-coated Fe sheath are obtained.

Attention must be paid to the wire drawing process so that the diffusion barrier layer maintains its continuity during processing. The Mg layer deposited on the inner walls of the Fe sheath is a soft and highly ductile material which will easily change shape and maintain its continuity at the interface walls.

The MgB₂ superconductor wires obtained by the method described above and the wires obtained by the present methods are subjected to the tests and the comparative results are evaluated on the graphs as described below.

### 1. Superconducting transition and temperature dependence of resistivity:

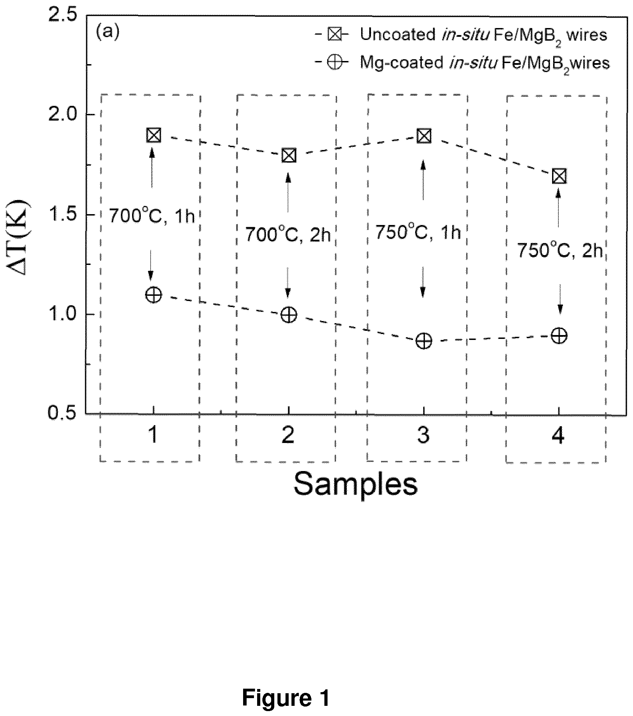

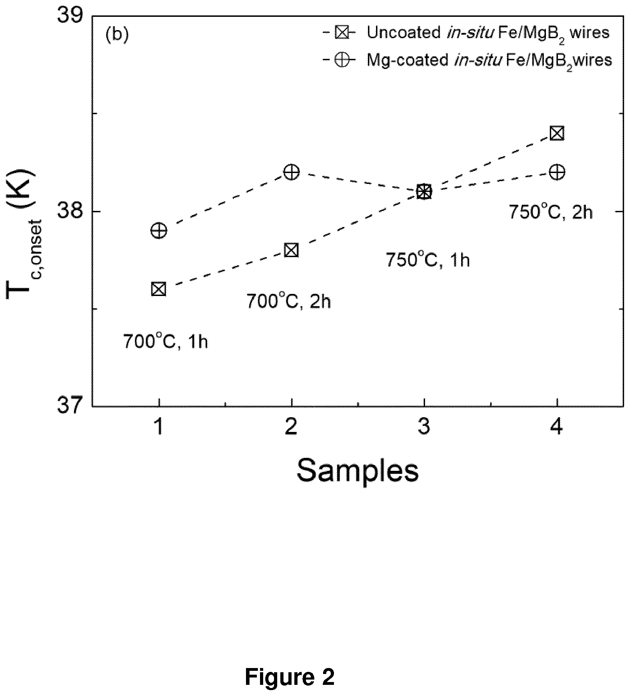

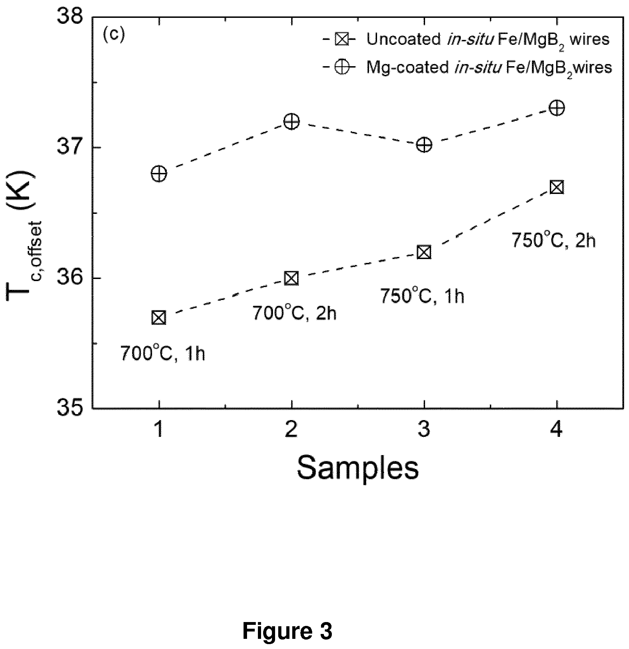

The superconducting transition and temperature dependence of resistivity were investigated for MgB₂ superconducting wires obtained by the method of the present invention and those obtained by the existing methods. Normal state resistivity values of MgB₂ superconducting wires obtained by using Mg-coated Fe sheath were found to be smaller than those of other wires. The superconducting transition temperature of the wires produced by using the Mg - coating method was higher than that of uncoated wires. The width (ΔT) in the resistivity-temperature graph of the superconducting wires is known as the transition width, and the transition width is small in the high-quality samples. It is known that there is an inverse relationship between the superconducting properties under the magnetic field and the transition width. As shown in Figure 1, the transition width values of uncoated wires are between 1.5 K and 2 K while the Mg-coated wires have the transition width values of 1 K or less. Figure 2 illustrates variation of onset critical transition temperatures (T_{c,onset}) in both group of wires and no significant difference is observed as expected. As seen in Fig. 3, Mg-coated wires show better performance when temperatures of zero resistance (T_{c, offset}) are considered.

### 2. Critical current density in self-field:

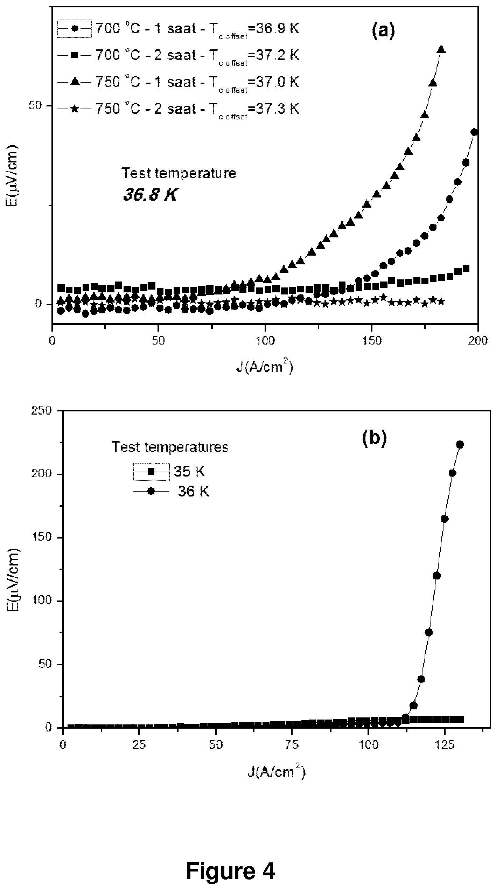

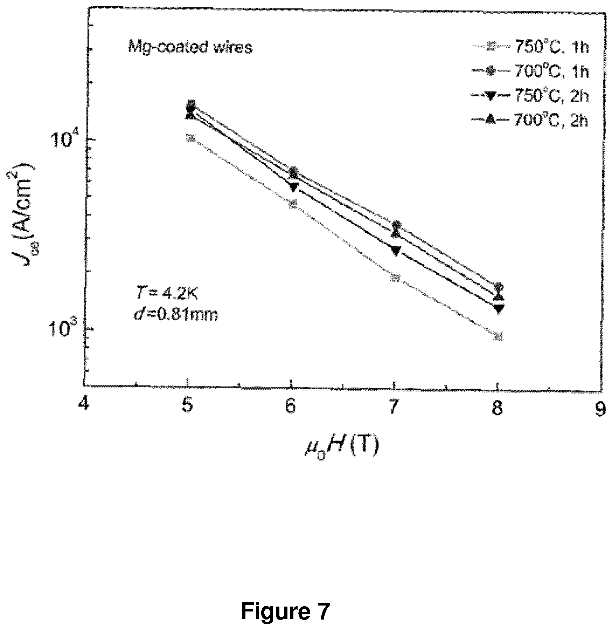

The MgB₂ superconducting wires obtained by the method of the present invention were subjected to critical current density tests by applying a maximum of 1A, while keeping the temperature constant 1 K or less below the transition temperature (T_{c, offset}). The results of these tests are given in Figure 4. The MgB₂ superconducting wires obtained by the existing techniques carry 0.5-1 A super current at 0.5-1 K below the critical transition temperature. In the case of present invention, MgB₂ superconducting wires fabricated with magnesium coated iron sheath have been observed to carry 0.5-1A at temperatures closer to critical transition temperature (T_{c, offset}) by 0.5K or less. When Figures 4a and 4b are compared, it is apparent that the wires made of Mg-coated iron tubes have better performances. A value close to the critical temperature will increase logarithmically as testing temperature goes down to lower values. It is seen from Fig. 7 that these wires perform very well under high magnetic field when measured at 4.2 K temperature.

### 3. Critical current density in an external magnetic field:

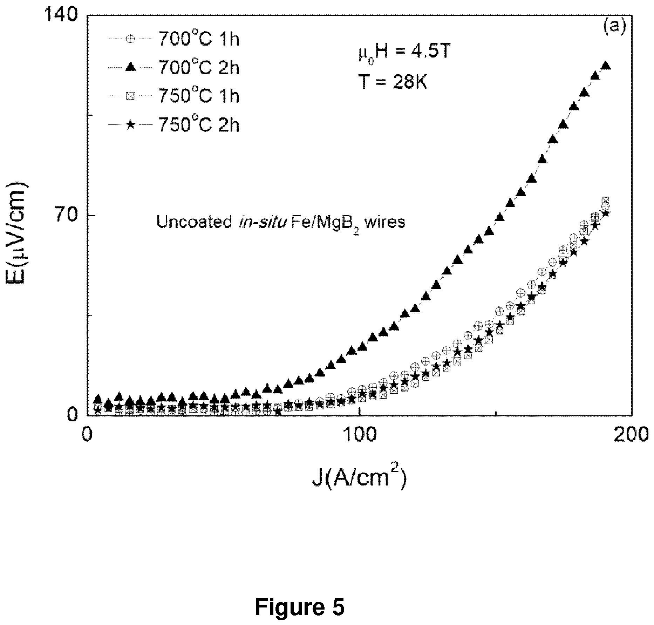

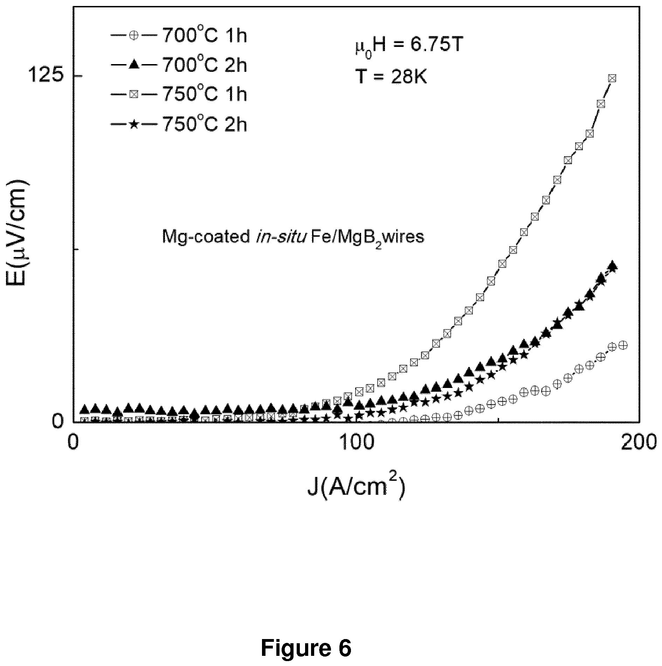

MgB₂ superconducting wires obtained by the method of the present invention are subjected to transport measurements at a constant temperature below the T_{c} and under the magnetic fields up to a maximum of 7 Tesla. Thus, the critical current density under the magnetic field is examined. E - J curves of 0.8 mm monocore wires obtained by the existing techniques are shown in Figure 5, a current of up to 1 A is passed through these wires under 4.5 T magnetic field at a constant temperature of 28 K. Fig. 6 shows E - J curves of the wires obtained by the inventive method of Mg-coating, the current of 1A is passed through the wires at a constant temperature of 28K under a much higher magnetic field of 6.75 T. This difference will be even greater at liquid hydrogen temperatures (20 K) which is one of the potential uses of MgB₂ wires. MgB₂ superconducting wires of 0.8 mm in diameter produced with Mg-coated Fe sheath were measured in liquid helium at a research center named "International Laboratory of High Magnetic Fields and Low Temperatures" (LHMFLT) and these wires have a direct current carrying capacity of greater than 150 A under a 4 T magnetic field (Figure 7). This current carrying performance was not achieved with the uncoated wires obtained by the present technique.

### 4. Phase formation:

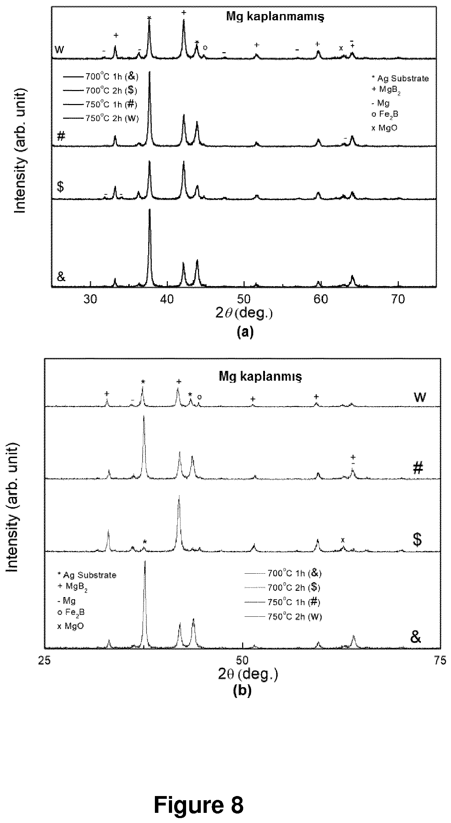

The XRD patterns shown in Figure 8 were obtained from mechanically removed MgB₂ extracts from the wires having an outer diameter of 0.8 mm. The powders obtained in different quantities can cause disproportion at peak heights in XRD patterns due to the difficulties in extracting the core from the iron sheath, The Ag peaks in the XRD patterns are derived from the silver platelet used as a carrier for powders.

The formation of Fe₂B phase was observed on the wires produced by both Mg-coated and uncoated iron tubes annealed for 1 hour at 700°C. It was determined that as the annealing temperature and the duration increased, the Fe₂B content also increased. Contrary to expectations, Mg-coating did not completely prevent the formation of Fe₂B phase in the interface region. There was no remarkable difference in MgO and unreacted Mg contents. It has also been observed that MgB₂ superconducting wires obtained by the Mg-coating method exhibit unreacted Mg phase which is dependent on the sintering temperature. As can be seen from the XRD patterns, the amounts of unreacted Mg are close to each other in the Mg-coated and uncoated samples as the sintering temperature increases. Insufficiency of XRD examinations due to the reasons mentioned above do not allow for drawing solid conclusions on the progress of phase formation.

### 5. Microstructure:

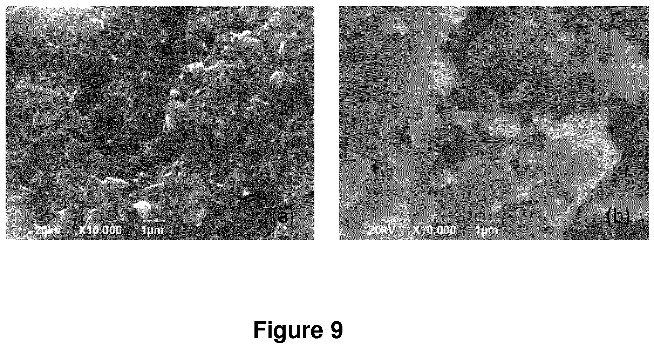

When the microstructure was observed by a scanning electron microscope (Fig. 9), it was observed that a spiky structure was formed in all Mg-coated MgB₂ superconducting wires. In the case of wires obtained by existing techniques, the structure was smoother and the particles were larger. It is very clear that the Mg coating affects the microstructure, the density of the grains and the grain size. The Mg layer which is coated on the iner walls of Fe sheath reacts more readily with B during the heat treatment process and causes more MgB₂ formation.

## Claims

1. A magnesium diboride superconducting wire for use in superconducting technology, consisting of monocore and/or multifilamentary, coated iron sheath, magnesium powder, amorphous boron powder, amorphous nano boron powder and **characterized in that** it consists of magnesium coating in inner wall of the said iron sheath.

2. A superconducting wire according to claim 1 and it is **characterized in that** consists of 50 - 85% iron sheath, 0,1 - 10% magnesium coating, 7 - 26% magnesium powder, 0,1 - 25% amorphous boron powder, 0,1 - 25% amorphous nano boron powder in weight.

3. A production method to obtain magnesium diboride superconducting wire for use in superconducting technology, consisting of monocore and/or multifilamentary, coated iron sheath, magnesium powder, amorphous boron powder, amorphous nano boron powder and **characterized in that** it consists of method steps of:
a) In-situ preparation of a mixture of magnesium diboride components,
b) Coating of the inner wall of the iron sheath with magnesium by sublimation and evaporation method,
c) Preparation of magnesium diboride superconducting wire by PIT / PEIT wire drawing-sintering method and inner wall magnesium coated iron sheath.

4. A method according to claim 3 and **characterized in that** "a" method step consists of process steps of
• mixture of magnesium powder, amorphous boron powder and amorphous nano boron powder in a manner to provide chemical stoichiometry of magnesium diboride,
• grinding of the obtained mixture by ball milling method under 1 - 5 bar argon gas pressure for 1 - 12 hours at 50 - 500 rpm.

5. A method according to claim 3 and it is **characterized in that** "b" method step consists of process steps of
• Thoroughly cleaning the inner and outer walls of the iron tube by use of ultrasonic vibration with alcohol and/or acetone, and then pressing and closing the bottom end,
• Friction welding sealing of the bottom end which is flattened,
• Applying a leakage test under 2 bars air pressure to the iron tube of which bottom end is closed,
• Filling Mg powder from the open end of the said iron tube passing the leakage test in an amount which is proportional to the empty volume of the sheath
• Pressing and closing the open end of the said iron tube without establishing full sealing,
• Placing the iron tube of which both ends are closed and having metallic magnesium powder into a cylindrical steel chamber,
• Fully closing the steel cylindrical chamber and putting it into the vertical furnace from top,
• Vacuuming the steel chamber and heating at 5°C/ min. until 600°C temperature,
• When heating is started, successively applying the vacuuming, filling argon gas of 1.5 bars high purity and re-vacuuming the cylindrical steel chamber until the furnace temperature reaches 100 ºC.
• When the temperature of the furnace reaches 200 °C, washing the steel cylindrical chamber again with 1.5 bars argon gas, vacuuming and then heating to 600 °C in an argon pressure of 1.5 bars,
• When the furnace temperature reaches 600 °C, vacuuming the steel chamber and applying heat treatment under vacuum for 1 hour at this temperature.
• After being held at 600 °C for 1 hour, washing ag ain with 1.5 bars argon gas and filling vacuum and keeping at the same temperature for 1 hour,
• Closing the furnace and leaving for free cooling down under 2 bars argon gas,
• Removing the steel chamber cooled to room temperature from the furnace and removing the iron tube of which inner wall is magnesium coated.

6. A method according to claim 3 and **characterized in that** "c" method step consists of process steps of
• Filling the magnesium diboride components mixture prepared at 'a' method step into iron sheath of which inner wall was coated with magnesium in 'b' method step and preparation of composite,
• Drawing and elongating the prepared composite by passing it through circular dies by employing cold wire drawing method and thinning it to a desired diameter,
• Applying intermediate heat treatments at 500 °C for strain relief during wire drawing at argon gas flow,
• Sintering the wire produced at temperatures of 700 °C - 750 °C for 1 - 2 hours in horizontal pipe furnace under 5 - 10 argon gas pressure and providing wires with superconducting feature.
